# EUROPEAN PATENT APPLICATION

(11) **EP 1 659 611 A1**
(43) Date of publication of application: **24.05.2006**
(21) Application number: 05024505.9
(22) Date of filing: 10.11.2005
(51) Int. Cl.: H01J 37/32

(54) **Plasma control method and plasma control apparatus**

(30) Priority: 22.11.2004 JP 2004338088
(71) Applicant: FUJI ELECTRIC HOLDINGS CO., LTD., Kawasaki 210-0858 (JP)
(72) Inventor: Shimosawa, Makoto, Chiyoda-ku Tokyo, 102-0075 (JP)
(74) Representative: Hoffmann, Eckart

(57) **Abstract**

The plasma control method according to the invention controls the distribution of a plasma (206), generated in a vacuum chamber (201) including an HF electrode (210) connected to an HF power supply (205) and an earth electrode (211) connected to the ground potential by high frequency-electric power fed to HF electrode (210), based on the peak-to-peak voltage values measured with peak-to-peak voltage measuring means disposed at multiple measuring points on HF electrode (210) or on earth electrode (211). The plasma control method according to the invention facilitates relating the film thickness uniformity variations caused by the variations of the film deposition conditions simply and easily with a measurable quantity, improving the film thickness uniformity in response to the variations of the absolute values and the distributions of the voltages Vpp caused depending on the time of lot manufacture, obtaining excellent characteristics uniformity, and improving the throughput of product manufacture.

## Description

The present invention relates to a plasma control method for controlling the distribution of a generated plasma. Specifically, the present invention relates to a plasma control method for controlling the distribution of the plasma generated by high-frequency (HF) electric power fed to an HF electrode in a vacuum chamber including the HF electrode and an earth electrode facing the HF electrode.

### BACKGROUND OF THE INVENTION

Thin film deposition using a plasma and etching using a plasma have been employed in many technical fields. A capacitive-coupling-type plane-parallel-plate plasma-assisted chemical vapor deposition apparatus (hereinafter referred to simply as a "PCVD apparatus") and a plasma etching apparatus have been used for plasma thin film deposition and for plasma etching. A thin film is deposited by making a gas for film deposition (or a gas for film formation: hereinafter referred to as a "film deposition gas") a gas such as SiH₄ (silane) flow into a vacuum chamber in an apparatus described above. Etching is conducted by making an etching gas such as CF₄ (fluoride gas) flow into a vacuum chamber in an apparatus described above.

Now the manufacture of a thin film solar cell by the plasma-assisted CVD (PACVD) method will be described exemplarily in connection with the formation of a thin film containing Si as the main component (hereinafter referred to simply as an "Si thin film") using a film deposition gas containing SiH₄ as the main component.

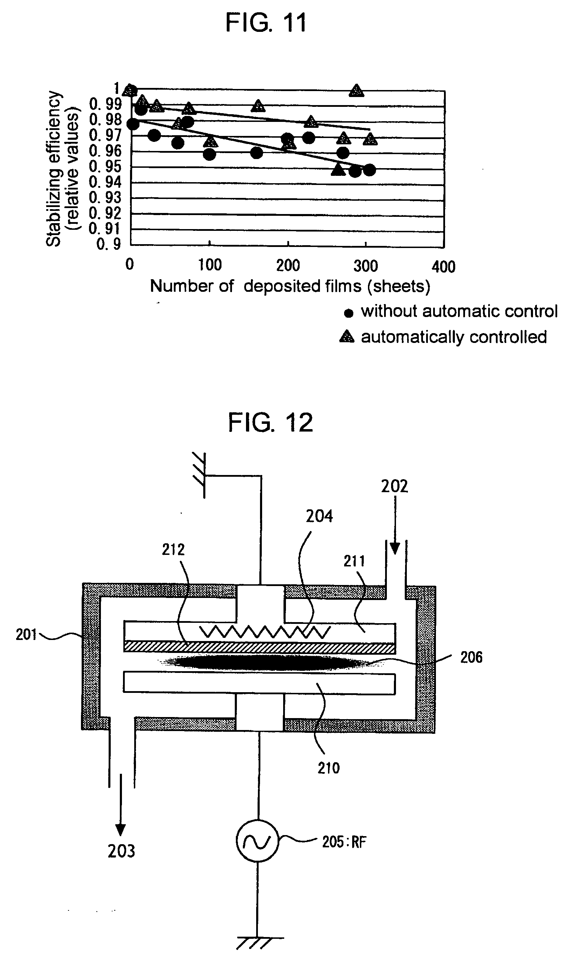

FIG. 12 is a cross sectional view schematically showing a conventional PCVD apparatus.

Referring now to FIG. 12, the conventional PCVD apparatus includes a vacuum chamber 201; an HF electrode 210 positioned in vacuum chamber 201 and supplied with HF (preferably RF) electric power fed from an HF (RF) electric power supply 205, and an earth electrode 211 positioned in vacuum chamber 201 and held at ground potential in this example. Note that DC power and/or AC power are applied with respect to ground potential as the reference potential. It is not always necessary, however, to apply ground potential to the earth electrode 211. Earth electrode 211 may include a mechanism for feeding DC electric power or high-frequency electric power thereto depending on the purposes thereof. Earth electrode 211 includes a mechanism for positioning a substrate 212 thereon and a heating mechanism (hereinafter referred to as a "heater") 204 therein for heating substrate 212. Substrate 212 may be positioned at an arbitrary position in vacuum chamber 201, such as on HF electrode 210, with no problem. Heater 204 may be positioned at an arbitrary position in vacuum chamber 201 or omitted from the CVD apparatus.

A thin film is deposited through the following steps.

First, the inside of vacuum chamber 201 is evacuated to a certain degree of vacuum through an exhaust system (an exhaust line 203 that leads to a vacuum pump or an exhaust pump). Then, substrate 212 is heated with heater 204, if necessary. Immediately after vacuum chamber 201 is evacuated, moisture and other impurities are adhered very often to the inner surface of vacuum chamber 201 and the surface of substrate 212. If a thin film is deposited in the state, in which these impurities are not sufficiently degassed, a large amount of impurities are contained in the thin film, impairing the film quality. To degas the inside of vacuum chamber 201, a gas is sent into vacuum chamber 201 through a gas feeder line 202 and the inside of vacuum chamber 201 is heated (baked) while the inside of vacuum chamber 201 is kept at the predetermined degree of vacuum by a not shown pressure controller and gas exhaust line 203. A gas such as H₂ that exhibits a relatively high thermal conductivity, an inert gas such as He and Ar, and a film deposition gas used for film deposition are employed for the gas that is made to flow during baking the vacuum chamber. The temperature of substrate 212 during the baking is set sometimes to be higher than the temperature of substrate 212 during the actual film deposition to facilitate degassing and to reduce the amount of gas occurring due to degassing during film deposition.

After the degassing is over, substrate 212 is set at the temperature, at which film deposition is conducted. The inside of vacuum chamber 201 is kept under an appropriate pressure by making a gas mixture, containing several kinds of film deposition gases mixed at an appropriate mixing ratio depending on the film to be deposited, flow. Then, a thin film is deposited on substrate 212 with a plasma 206 generated between HF electrode 210 and earth electrode 211 by applying electric power to the electrode 210. Plasma 206 is generally called a "low-temperature plasma".

The conditions for the film deposition described above are very important for determining the thin film quality, the film deposition speed, and the film thickness uniformity in the effective film deposition area. The film deposition conditions include hardware configuration conditions such as the spacing between HF electrode 210 and earth electrode 211 (hereinafter referred to as the "electrode spacing") and the frequency of HF power supply 205. The film deposition conditions for depositing an Si thin film, for instance, include the hydrogen dilution rate that is the flow rate ratio of a film deposition gas SiH₄ and a diluent gas H₂, the temperature of substrate 212, the film deposition pressure, the frequency of HF power supply 205, the supplied electric power, and the electrode spacing. These conditions affect each other in determining the thin film properties.

As one way of selecting the film deposition conditions, JP 2004-253417 A (cf. FIGs. 3 and 5 and their description) describes that a photoelectric converter device that exhibits excellent photoelectric conversion characteristics is obtained by depositing a photoelectric conversion layer at a hydrogen amount ratio (SiH₂/SiH), which is a ratio of the hydrogen amount in the SiH₂ bondings to the hydrogen amount in the SiH bondings in the photoelectric conversion layer, set at 0.3 or smaller and at a peak-to-peak voltage Vpp, which is the average value of the HF voltage applied between the electrodes, set at 300 V or lower. This document describes also that there exists a strong correlation between the voltage Vpp and the photoelectric conversion characteristics and that the photoelectric conversion characteristics get better with a decrease in voltage Vpp (preferably Vpp ≤ 200 V).

The documents JP 2000-164520 A, JP 2001-257098 A and JP 2002-313743 A describe improving means for improving the thickness uniformity in the effective film plane. The improving means described in JP 2000-164520 A includes high-voltage variable capacitors disposed on the HF-power-supply side of an HF electrode for generating a plasma and on the opposite side thereof. The film thickness uniformity improvement described in JP 2000-164520 A makes the plasma potential uniform in film deposition by changing the phase of the HF power using the high-voltage variable capacitors. In JP 2001-257098 A the voltage distribution caused on the discharging electrode is changed by changing the phase and such a parameter of the HF power with time. In JP 2002-313743 A the distribution caused in the film thickness is reduced by making the phase of the HF voltage different on adjacent small electrodes. Each of these documents employs a technique for making uniform the plasma distribution that exhibits a correlation with the film thickness uniformity by changing the apparatus configurations for film deposition.

Although the voltage Vpp has been one of the film deposition conditions to be selected, no attention has been paid to the use of the voltage Vpp for improving the film thickness uniformity. JP 2004-253417 A describes embodiments that apply frequencies of 13.56 MHz and 27.12 MHz for manufacturing a solar cell on a film substrate having a film deposition area of 40 cm×80 cm. However, the wavelength of the electric power and the electrode size become almost the same when the electrode area is widened to be on the level of 1 m × 1 m or when the frequency is raised. As the wavelength of the electric power and the electrode size become almost the same, the film thickness uniformity in the effective film plane may be impaired.

The conventional improving means improve the film thickness uniformity by improving the apparatus configurations for film deposition related, for example, with the electric power supply scheme. Therefore, no attention has been paid to the measurable quantities related with the film thickness uniformity change caused by the change of the film deposition conditions.

Means for measuring the plasma distribution exhibiting a correlation with the film thickness uniformity have been existing. The means for measuring the plasma distribution include a prove method that inserts a probe into the plasma and a spectroscopic method. However, the prove method causes large errors in and by the film deposition atmosphere, more particularly the atmosphere is influenced and the probe the suffers from a film being deposited thereon. The spectroscopic measurement requires a large-scale measuring system for measuring the film thickness uniformity in a wide area. Therefore, the conventional means for measuring the plasma distribution exhibit respective limits in measuring the plasma distribution uniformity in a wide area. It has been difficult to apply any of the conventional means for measuring the plasma distribution to a manufacturing apparatus working in practice on a production line except for to the manufacturing apparatus designed with the application of any of the means for measuring the plasma distribution in consideration. When the apparatus is designed considering the plasma measurement, the manufacturing costs of the apparatus will soar.

When the voltage Vpp of the HF electrode is considered, the absolute value of the voltage Vpp and the distribution of the voltage Vpp are different not only from lot to lot but also between the early stage and the late stage of the same lot. Since manual cleaning is conducted for every lot, the variations are caused in the voltage Vpp and the absolute value thereof at the time when the manual cleaning is conducted. It is considered that the variations of the voltage Vpp and the absolute value thereof are caused between the early stage and the late stage of lot manufacture due to the increasing powder amount on the wall of the film deposition room increasing with repeated film deposition operations.

It is a first object of the invention to provide a plasma control method that allows obtaining relatively simply and easily an improving means (guide line) for improving the film thickness uniformity considering the measurable quantities related with the film thickness uniformity change caused by the change of the film deposition conditions.

It is a second object of the invention to provide a plasma control method that allows achieving the first object while reducing the measurement errors not with a large-scale measuring system but with a low-costs control apparatus.

It is a third object of the invention to provide a plasma control method that allows obtaining very uniform film characteristics and improving the throughput of manufacture in response to the characteristics variations such as the variations of the absolute value and the distribution of the voltage Vpp caused from lot to lot and in response to the characteristics variations caused depending on the time of manufacture of one lot such as the early stage of lot manufacture and the late stage of lot manufacture.

It is a fourth object of the invention to provide a plasma control method that does not impair the thickness uniformity in the film plane, even when the electrode area is widened to be on the level of 1 m x 1 m or even when the power supply frequency is raised.

These objects are achieved by a plasma control method as claimed in claim 1 and its preferred embodiments as claimed in the dependent claims, as well as by a plasma control apparatus as claimed in claim 9.

By the plasma control method according to the invention, the peak-to-peak voltage Vpp is measured at multiple measuring points on an HF electrode prior to forming a photoelectric converter device in practice in manufacturing a thin film Si solar cell by depositing a thin film of amorphous Si or micro-crystalline Si on a flexible substrate positioned in a PCVD apparatus. Even when the voltage Vpp is measured at multiple measuring points on the HF electrode, the voltage Vpp is measured with measuring means disposed easily with low costs. Since the distribution of the voltage Vpp exhibits a certain correlation with the potential distribution on the HF electrode and a certain correlation with the plasma distribution, an excellent film thickness uniformity is obtained by monitoring the distribution of the voltage Vpp on the HF electrode and by selecting the film deposition conditions so that the voltage Vpp on the HF electrode may be nearly the same at all measuring points. In other words, a relatively simple and easy improving means (guide line) for improving the film thickness uniformity, which employs the distribution of the voltage Vpp on the HF electrode as a measurable quantity related with the change of the film thickness uniformity caused by the change of the film deposition conditions, is obtained and the film deposition conditions are optimized simply and easily.

The voltage Vpp on the HF electrode is measured relatively easily with small measurement errors and with low costs without using any large-scale measuring means. By using the monitored values of the voltage Vpp for the other control mechanisms for controlling the other film deposition conditions such as a pressure control mechanism and by controlling the other film deposition conditions based on the monitoring results, excellent film thickness uniformity is obtained simply and easily in response to the variations of the absolute values and the distribution of the voltage Vpp caused from lot to lot and in response to the variations caused depending on the time of lot manufacture such as the early stage of lot manufacture and the late stage of lot manufacture, and the throughput of product manufacture is improved. Since the plasma uniformity is important for the etching using the plasma and affects the uniformity of the etching, the plasma control method according to the invention is effective for plasma etching control.

The invention will be described below in detail with reference to the accompanied drawings which illustrate preferred embodiments of the invention, and in which:
- FIG. 1: is a cross sectional view of entire installation including a PCVD apparatus according to a first embodiment of the invention;
- FIG. 2: is a top plan view of an HF electrode showing the measuring points set thereon for measuring the peak-to-peak voltage thereon;
- FIG. 3: is a top plan view of a solar cell having a back electrode on the back surface (the opposite major surface opposite to the solar cell) of the substrate;
- FIG. 4(a) through 4(g): are cross sectional views along line XX of FIG. 3 describing the manufacturing steps for manufacturing the solar cell shown in FIG. 3;
- FIG. 5: shows a set of curves relating the voltage Vpp with the film deposition pressure with the HF power frequency set at 13 MHz;
- FIG. 6: shows a set of curves relating the voltage Vpp with the film deposition pressure with the HF power frequency set at 27 MHz;
- FIG. 7: shows a set of curves describing the thickness distributions of the i-layer deposited under different film deposition pressures with the HF power frequency set at 13 MHz;
- FIG. 8: shows a set of curves describing the thickness distributions of the i-layer deposited under different film deposition pressures with the HF power frequency set at 27 MHz;
- FIG. 9: shows a couple of curves describing the characteristics of the solar cells manufactured by the plasma control method according to the first embodiment of the invention;
- FIG. 10: relates the automatically controlled pressure values with the number of the films deposited;
- FIG. 11: shows a couple of plots relating the relative stabilizing efficiencies of the solar cells with the number of the films deposited;
- FIG. 12: is a cross sectional view schematically showing a conventional PCVD apparatus; and
- FIG. 13: is a perspective view of a cut plane of a solar cell formed according to the first embodiment of the invention.

### First embodiment

Now the plasma control method according to a first embodiment of the invention will be described below. A thin film Si solar cell is manufactured by depositing an Si thin film such as an amorphous Si thin film (hereinafter referred to as "a-Si thin film") and a micro-crystalline Si thin film (hereinafter referred to as a "µc-Si thin film") in a PCVD apparatus. An electric power supply (HF power supply), the frequency thereof being set at 13 MHz or 27 MHz, is connected to an HF electrode (first electrode) and an earth electrode (second electrode) is grounded. The electrodes are 1 m×1 m in area each. The HF power supply is connected to the HF electrode at multiple power supply points intentionally positioned thereon to obtain a uniform potential distribution or to obtain a uniform plasma distribution over the HF electrode. Although the electrodes are shaped like a plate, one of them may be a ladder-shaped electrode. It is not always necessary to hold the earth electrode at ground potential. Alternatively, for the earth electrode a power supply means may be provided for supplying high-frequency electric power or DC electric power with no problem. A shower electrode is employed as the HF electrode and gases are fed from the HF electrode. The manner of gas feed is limited to the scheme described above. Although a film substrate is used according to the first embodiment, a glass substrate or a stainless steel substrate may be used alternatively.

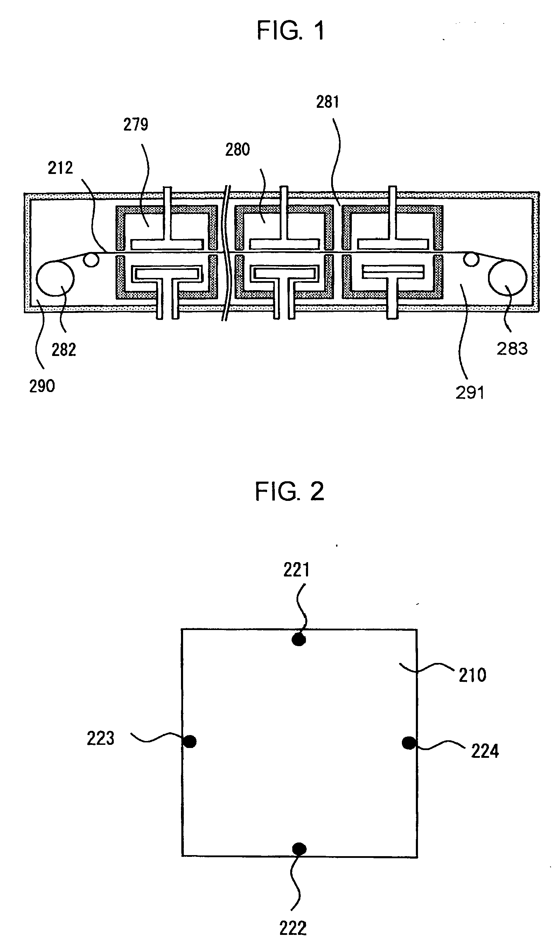

FIG. 1 is a cross sectional view of the entire installation including a PCVD apparatus (i.e., a plasma control apparatus) according to a first embodiment of the invention.

Referring now to FIG. 1, the PCVD apparatus has a structure that allows depositing films by the stepping roll scheme, in which a substrate is fed to a film deposition room, stopped for film formation and subsequently advanced further. In FIG. 1, an unwinder room 290 for unwinding a flexible substrate 212; a film deposition room 280, which is an independent treatment space for depositing a metal electrode layer, a photoelectric conversion layer or a transparent electrode layer on flexible substrate 212; a preheating room 279 positioned between unwinder room 290 and the film deposition room 280; a winder room 291 for winding flexible substrate 212; and a common room 281 housing preheating room 279 and the plurality of film deposition rooms 280 are shown. Although only one film deposition room 280 is shown in FIG. 1 for the sake of drawing convenience, the PCVD apparatus according to the invention may include multiple film deposition rooms 280. Preheating room 279 includes a heater for heating flexible substrate 212 prior to depositing a thin film photoelectric conversion layer on flexible substrate 212, a gas feeder line, an exhaust line, and an adjusting mechanism for adjusting the gas pressures. The heater, the gas feeder line, the exhaust line and the gas pressure adjusting mechanism are not shown in FIG. 1. Flexible substrate 212 is unwound off a core 282 and preheated in preheating room 279. After the preheating, constituent thin films are deposited on flexible substrate 212 in the respective film deposition rooms 280 and, then, flexible substrate 212 with the constituent thin films deposited thereon is wound onto a core 283. Since the internal structure of film deposition room 280 is the same as the internal structure of the PCVD apparatus shown in FIG. 12, it need not be described again here. The same reference numerals as used in FIG. 12 are used to designate the same constituent elements in Fig. 1.

Although plasma-CVD is used usually for forming the constituent thin films, other methods such as sputtering, vapor deposition, cat-CVD (catalytic CVD), and photo-CVD may be used alternatively. A stainless steel foil substrate and such an electrically conductive substrate, a polyimide substrate, a polyethylene naphtahalate (PEN) substrate, a polyether sulfone (PES) substrate, a polyethylene terephtalate (PET) substrate, an aramid fim substrate and such heat-resistive plastic substrates may be used as the flexible substrate 212. If not limited to a flexible one, a stainless steel substrate and a glass substrate may be used. An nip-type single cell, formed of a substrate, an n-type layer formed on the substrate, an i-layer (intrinsic layer) formed on the n-type layer, a p-type layer formed on the i-layer, and an ITO (indium tin oxide) layer on the p-type layer, is manufactured for a photoelectric converter device.

According to the first embodiment, the voltage Vpp is measured at four measuring points on HF electrode 210 in the i-layer deposition room. FIG. 2 is a top plan view of HF electrode 210 showing the measuring points set thereon. The four measuring points are: a measuring point 221 (upper measuring point), a measuring point 222 (lower measuring point), a measuring point 223 (left measuring point), and a measuring point 224 (right measuring point). The voltage Vpp is measured at the measuring points 221, 222, 223, and 224.

Vpp may be measured by means of an oscilloscope, for instance. However, any means capable of detecting Vpp combined with means to display the result of the detection may be used. When automatic control on the basis of Vpp is employed in the invention, means for transmitting information about Vpp to the controller may be additionally included. Measuring points of Vpp may be the points shown in Fig. 2 for example. A coaxial cable is suitable for the signal transfer of Vpp. In case of an oscilloscope, its ground terminal is connected to a fully grounded portion for example the vacuum chamber.

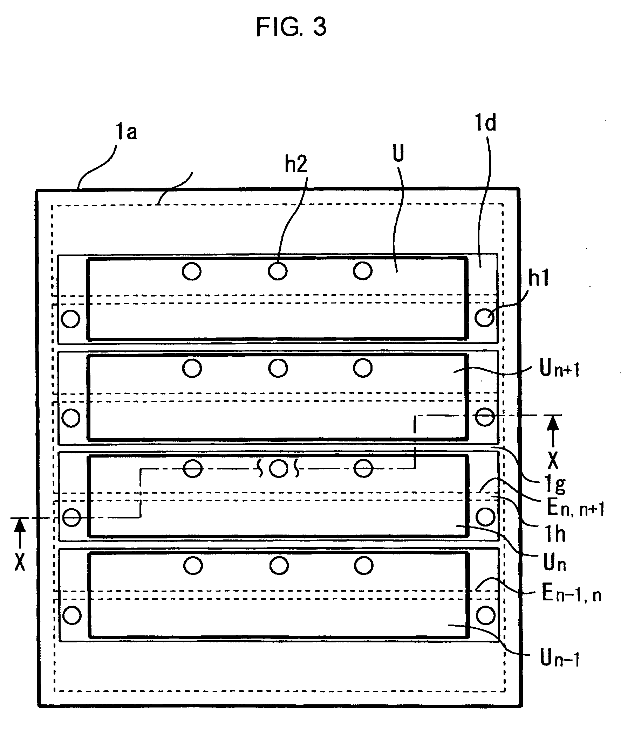

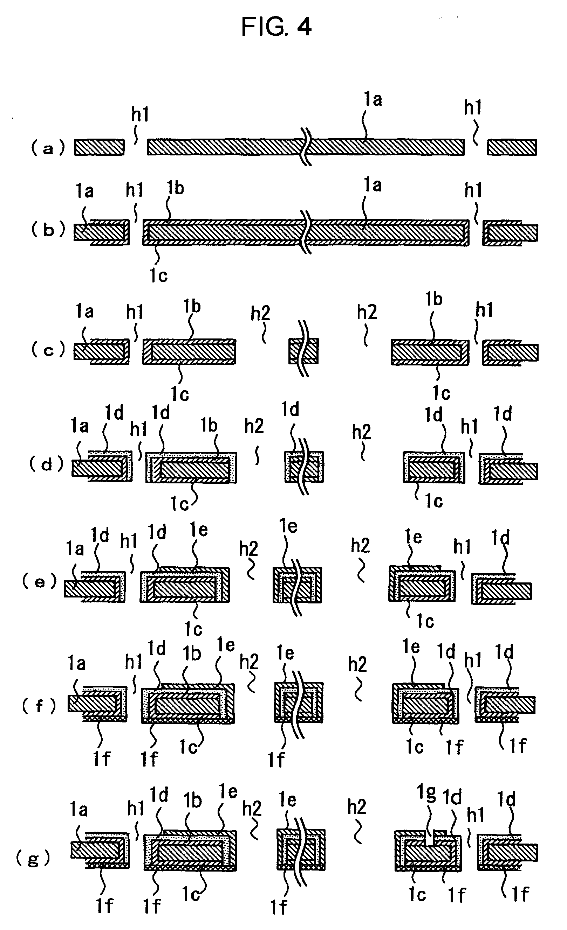

Now a method of manufacturing a solar cell will be described in detail below. A pin-type a-Si solar cell, having a power generation area of 1 m² and a series structure called a "series connection through apertures formed on film (SCAF) structure" (cf. JP 6 -342924 A (1994) and JP 8-340125 A (1996)), is manufactured. FIG. 3 is a top plan view of a solar cell having a back electrode E on the back surface (the major surface opposite to the solar cell). FIGs. 4(a) through 4(g) are cross sectional views along line XX of FIG. 3 describing the manufacturing steps for manufacturing this solar cell.

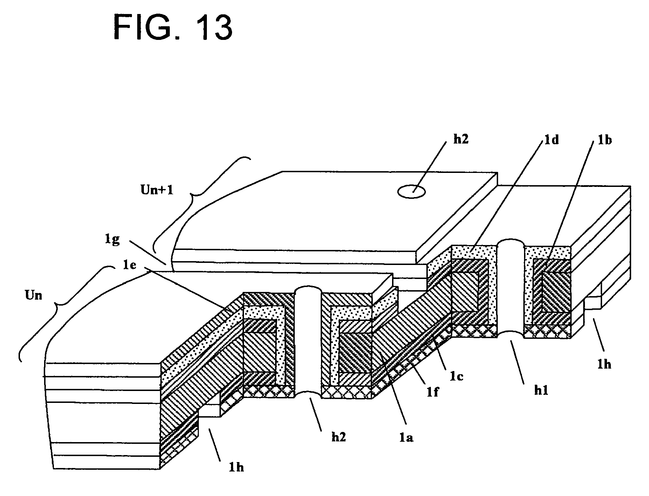

Referring now to these figures, two electrode layers (a first electrode layer 1b and a third electrode layer 1 e) are deposited on one major surface of a substrate 1 a (flexible substrate 212) such as a plastic substrate with a photoelectric conversion layer 1d interposed between the first and third electrode layers 1b and 1 e. Two other electrode layers (back electrode E consisting of a second electrode layer 1c and a fourth electrode layer 1f) are deposited on the other major surface (back surface) of substrate 1 a. Electrode layers 1b, 1 e and photoelectric conversion layer 1d on substrate 1a are divided by patterning lines (cutting sections 1g) into unit cells U (Uₙ₋₁, Uₙ, Uₙ₊₁), which are connected in series to each other. As shown in FIG. 3, unit cell Uₙ is cut out by cutting sections 1g such that it includes collector holes h2, and that third electrode layer 1e on the major surface of substrate 1a is connected electrically to second electrode layer 1c and fourth electrode layer 1f (back electrode E) on the back surface of substrate 1a only in collector holes h2. Back electrode E for unit cell Uₙ is cut out by cutting sections 1h such that connection holes h1 for unit cell Uₙ and collector holes h2 for unit cell Uₙ₋₁ belong to back electrode E. Third electrode layer 1 e for unit cell Uₙ and back electrode E are connected electrically to each other in connection holes h1. Therefore, adjacent back electrodes Eₙ₋₁, ₙ and Eₙ, ₙ₊₁, adjacent to each other and adjacent to an arbitrary unit cell Uₙ, are connected in series via the unit cell Uₙ such that multiple series connections of unit cell Uₙ and back electrode E are connected in series, forming a solar cell. FIG. 13 is a perspective view of the solar cell formed as described above including a zigzag cross section for illustrating the relations between the electrode layers and the unit cells connected in multi-series. In FIG. 13, cutting section 1g and cutting section 1h are exaggerated to clearly describe the connections between the electrode layers.

Now the manufacturing steps for manufacturing the above described solar cell will be described below with reference to FIGs. 4(a) through 4(g). FIG. 4(a) describes the step of forming connection holes. FIG. 4(b) describes the step of depositing a first electrode layer and a second electrode layer. FIG. 4(c) describes the step of forming collector holes. FIG. 4(d) describes the step of depositing a photoelectric conversion layer. FIG. 4(e) describes the step of depositing a third electrode layer. FIG. 4(e) describes the step of depositing a fourth electrode layer. FIG. 4(g) describes the step of forming a cutting section. In FIGs. 4(a) through 4(g), the same reference symbols as used for designating the drawing figures are used also for designating the manufacturing steps.

Referring now to FIG. 4(a), connection holes h1 are bored at predetermined positions in substrate 1a a (step (a)). Connection hole h1 is around 1 mm in diameter. Referring now to FIG. 4(b), a first electrode layer 1b is deposited on one surface (hereinafter referred to as a "front surface") of substrate 1 a, Then, a second electrode layer 1c is deposited on the back surface of substrate 1 a facing in a direction opposite to that of the front surface. Second electrode layer 1c may be deposited first, prior to depositing first electrode layer 1b with no problem. First and second electrode layers 1b and 1c overlap each other in connection holes h1 such that first and second electrode layers 1b and 1c are connected electrically to each other (step (b)). First and second electrode layers 1b and 1c are Ag layers of several hundreds nm in thickness deposited by sputtering. Referring now to FIG. 4(c), collector holes h2 are bored at predetermined positions in substrate 1 a (step (c)).

Referring now to FIG. 4(d), a photoelectric conversion layer 1d is deposited on first electrode layer 1b such that photoelectric conversion layer 1d covers the inner surfaces of connection holes h1 and the inner surfaces of collector holes h2 (step (d)). In the film deposition step (d), the PCVD apparatus (i.e., the plasma control apparatus) prepared as described earlier is used. According to the first embodiment, an a-Si film is deposited as the i-layer.

Prior to forming the non-crystalline photoelectric converter device in practice, the voltage Vpp is measured at multiple measuring points on HF electrode 210. According to the first embodiment, potential measurement is conducted using an oscilloscope. The conditions for film deposition include the frequency of the HF power from the HF power supply 205 and the film deposition pressure as parameters. The frequency is set at 13 MHz or 27 MHz. The film deposition pressure is varied between 40 Pa and 400 Pa. Other film deposition conditions include the hydrogen dilution rate (H₂/SiH₄) set at 10 and the electric power density of the HF power set at 60 mW/cm².

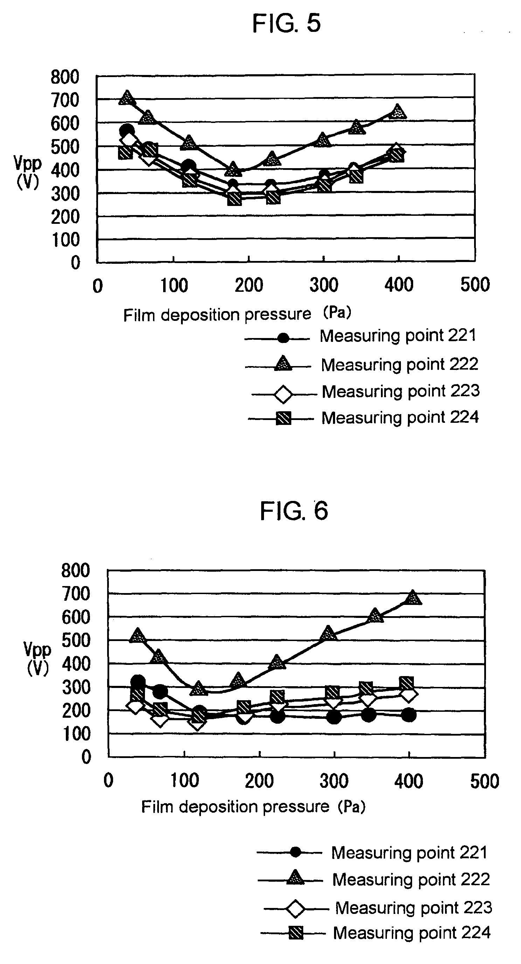

FIG. 5 shows the results measured for the HF power from HF power supply 205 having a frequency of 13 MHz. FIG. 6 describes the results measured for the frequency being set at 27 MHz. In FIGs. 5 and 6, the vertical axis represents the voltage Vpp (V) and the horizontal axis the film deposition pressure (Pa). In FIGs. 5 and 6, the black circles represent the results measured at the upper measuring point 221, the hatched triangles the results measured at the lower measuring point 222, the rhombuses the results measured at the left measuring point 223, and the hatched squares the results measured at the right measuring point 224. As one knows from FIGs. 5 and 6, the differences between the absolute value of the voltage Vpp measured at the lower measuring point 222 and the absolute values of the voltages Vpp measured at the other three measuring points become wider as the film deposition pressure increases. The voltage differences for the frequency of 27 MHz are wider than those for the frequency of 13 MHz. As shown in FIGs. 5 and 6, it is preferable for the voltage Vpp measured at the respective measuring points to be 300 V or lower.

For depositing the i-layer of the photoelectric converter device, the frequency of the HF power is set at 13 MHz and 27 MHz and the film deposition pressure at 67 Pa, 180 Pa, and 300 Pa according to the first embodiment. Photoelectric converter devices are fabricated for all the combinations of these frequencies and the film deposition pressures. The film deposition speed is calculated using the film thickness calculated optically and the film deposition periods for the a-Si thin films deposited in advance under the i-layer deposition conditions. Eleven measuring points are selected for measuring the film deposition speed on a diagonal line connecting the lower left corner and the upper right corner of the effective film deposition area. In fabricating single cells, the film deposition period is adjusted based on the measured film deposition speed so that the designed film thickness may be 300 nm. The i-layer thickness is measured optically again after fabricating the single cells. It is confirmed that the i-layer thickness is around 300 nm.

Referring now to FIG. 4(e), a transparent electrode layer is deposited on photoelectric conversion layer 1d as a third electrode layer 1e. Electrically conductive oxide layers of ITO (indium tin oxide), Sn02, or ZnO are used generally for transparent electrode layer 1 e. During depositing transparent electrode layer 1e, connection hole h1 and the vicinity thereof are covered with a mask so that no transparent electrode layer is formed in connection hole h1 and the vicinity thereof (step (e)). Referring now to FIG. 4(f), a fourth electrode layer 1f formed of a metal film or another electrically conductive film with low resistance is deposited on the back surface (step (f)). As a result of the step (f), third electrode layer 1e and fourth electrode layer 1f overlap each other in collector holes h2 such that third electrode layer 1e and fourth electrode layer 1f are connected electrically to each other.

After the steps (a) through (f) are completed, the laminates on both major surfaces of substrate 1a are cut into predetermined shapes, resulting in a solar cell formed of unit cells Uₙ connected in multi-series (step (g)). In FIG. 4(g), the electrode layers being at the same potential when the solar cell, to which light is irradiated, is generating electricity are hatched in the same fashion. In FIG. 4(g), cutting section 1g is shown perpendicular to the extending direction thereof. As described earlier, unit cells Uₙ are cut out by cutting sections 1g such that unit cell Uₙ includes collector holes h2 only and third electrode layer 1e on unit cell Uₙ and fourth electrode layer 1f on the back surface are connected to each other only in holes h2. Therefore, an arbitrary unit cell Uₙ and back electrodes E_{n-1, n} and E_{n, n+1}, adjacent to each other are connected in series, i.e., back electrode E_{n-1, n} to unit cell Uₙ and unit cell Uₙ to back electrode E_{n, n+1}. Thus, a predetermined solar cell connected in multi-series is formed. Then, the step of applying a reverse bias voltage to the formed solar cell and the step of assembling the solar cell biased in reverse into a module are conducted and the manufacture of the sample solar cell is completed.

The manufactured sample solar cells are loaded into a solar simulator to be subjected to an artificial light source radiating light at a light intensity of 100 mW/cm² and exposed to the light for 300 hr to measure the cell characteristics deteriorated by the light exposure. Then, the irradiated sample solar cells are taken out of the solar simulator and the IV-characteristics thereof are measured under white light (100 mW/cm²). Temperature correction is conducted to correct the measured data to the values at 25 °C.

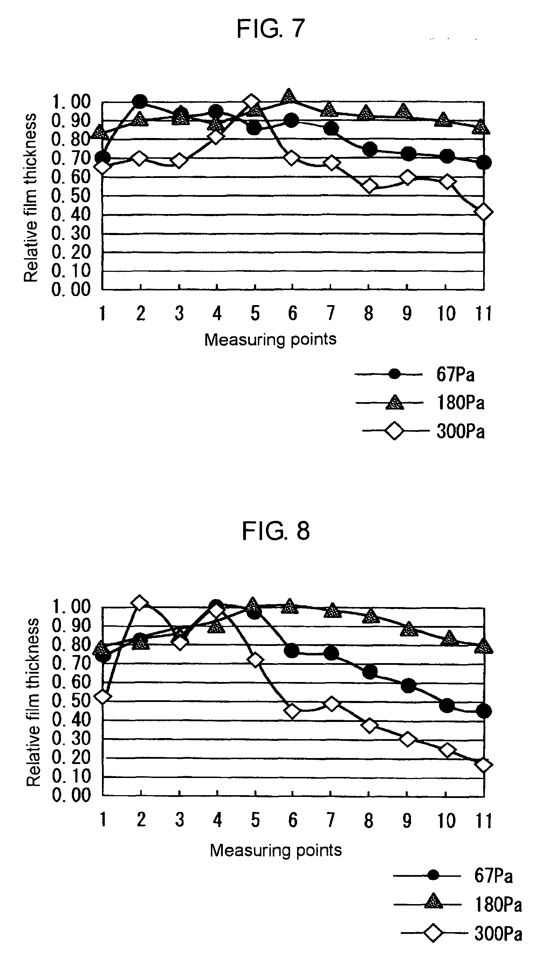

FIG. 7 shows a set of curves describing the thickness distributions of the i-layer deposited under different film deposition pressures (at an HF power frequency of 13 MHz). FIG. 8 shows a set of curves describing the thickness distributions of the i-layer deposited under different film deposition pressures (at an HF power frequency of 27 MHz). In FIGs. 7 and 8, the horizontal axis represents the 11 measuring points on the diagonal line connecting the lower left corner and the upper right corner of the effective film deposition area. The measuring point 1 corresponds to the lower left corner of the effective film deposition area, the measuring point 6 to the center of the effective film deposition area, and the measuring point 11 to the upper right corner of the effective film deposition area. In FIGs. 7 and 8, the vertical axis represents the relative film thickness normalized such that the maximum film thickness at the measuring point 11 is 1. In FIGs. 7 and 8, the black circles represent the relative film thickness deposited under the film deposition pressure of 67 Pa, the hatched triangles the relative film thickness deposited under the film deposition pressure of 180 Pa, and the rhombuses the relative film thickness deposited under the film deposition pressure of 300 Pa. As shown in FIGs. 7 and 8, the film thickness uniformity becomes worse as the differences between the absolute values of the voltage Vpp are wider. Under the conditions, under which the film thickness uniformity is not good, the voltage Vpp is high in the lower portion of the effective film deposition area, and, in response to this, the relative film thickness is larger in the lower portion of the effective film deposition area than in the upper portion thereof.

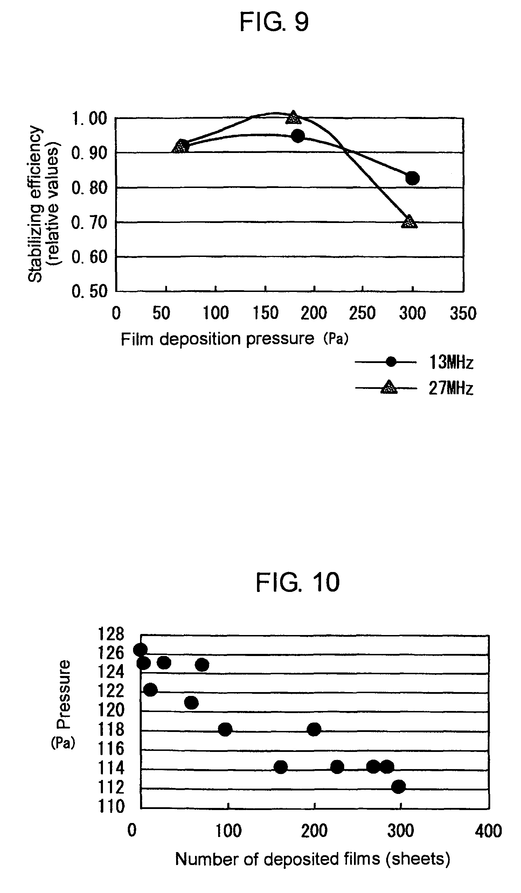

FIG. 9 shows a couple of curves describing the characteristics of the solar cells manufactured by the plasma control method according to the first embodiment of the invention. In FIG. 9, the horizontal axis represents the film deposition pressure (Pa) and the vertical axis the relative stabilizing efficiency normalized such that the maximum relative stabilizing efficiency at the measuring point 6 is 1. In FIG. 9, the black circles represent the relative stabilizing efficiencies at an HF power frequency of 13 MHz and the hatched triangles the relative stabilizing efficiencies at a frequency of 27 MHz. When the HF power frequency is 13 MHz or 27 MHz, a solar cell manufactured at a film deposition pressure of 180 Pa exhibits the best stabilizing efficiency presumably because the film thickness uniformity over the entire solar cell is excellent and because the film deposition pressure, at which the voltage Vpp is low, is selected. At film deposition pressures of 67 Pa and 180 Pa, a solar cell manufactured at 27 MHz exhibits almost the same or better solar cell characteristics than a solar cell manufactured at 13 MHz, although the film thickness uniformity in the solar cell manufactured at 27 MHz is worse than the film thickness uniformity in the solar cell manufactured at 13 MHz. It is considered that these results are obtained because the absolute value of the voltage Vpp is lower at the frequency of 27 MHz than at the frequency of 13 MHz and because less film quality deterioration is caused by ion damages at 27 MHz than at 13 MHz. It has been confirmed that the ratio of the hydrogen amount in the SiH₂ bondings to the hydrogen amount in the SiH bondings (SiH₂/SiH) in the i-layer in the solar cells manufactured under these conditions is between 0.1 and 0.3 (preferably 0.3 or smaller). In the solar cells manufactured under the film deposition pressure of 180 Pa, the film deposition rate at the frequency of 27 MHz is 1.5 times as fast as the film deposition rate at 13 MHz. Therefore, it is more preferable to select the HF power frequency to be 27 MHz than 13 MHz according to the first embodiment.

According to the first embodiment of the invention, a thin film Si solar cell is manufactured by depositing an Si thin film such as an a-Si thin film and a µc-Si thin film in a PCVD apparatus. In the PCVD apparatus, the electrode size is set at 1 m x 1 m, HF power supply 205 is set to a frequency of 13 MHz or 27 MHz and is connected to HF electrode 210, and earth electrode 211 is grounded. HF power supply 205 is connected to HF electrode 210 at multiple power supply points intentionally positioned thereon to obtain a uniform potential distribution and thus a uniform plasma distribution over HF electrode 210. Prior to forming a photoelectric converter device in practice, the voltage Vpp is measured at multiple measuring points on HF electrode 210. The conditions for film deposition include the frequency of the HF power and the film deposition pressure as parameters. The frequency of the HF power is set at 13 MHz or 27 MHz. The film deposition pressure is varied between 40 Pa and 400 Pa. The other film deposition conditions include the hydrogen dilution rate (H₂/SiH₄) set at 10 and the electric power density of HF power supply 205 set at 60 mW/cm². It is relatively easy to measure the peak-to-peak voltage Vpp on HF electrode 210. It is possible to measure the voltage Vpp at multiple measuring points on HF electrode 210 easily with low costs. Since the distribution of the voltage Vpp exhibits correlation with the potential distribution on HF electrode 210 and correlation with the plasma distribution, excellent film thickness uniformity is obtained by monitoring the distribution of the voltage Vpp on HF electrode 210 and by setting a control step for selecting the film deposition conditions which make the voltage Vpp at the respective measuring points on HF electrode 210 nearly the same. In other words, a means (guide line) for improving the film thickness uniformity is obtained by selecting the distribution of the voltage Vpp on HF electrode 210 as a measurable quantity related with the film thickness uniformity change caused by variations in the film deposition conditions and the film deposition conditions are optimized simply and easily. Since the voltage Vpp is measured relatively easily on HF electrode 210, measurement errors are reduced, it is not necessary to employ any large-scale measuring system, and the apparatus costs are reduced. It is possible to prevent the thickness uniformity in the film plane from being impaired even when the electrode area is widened to be on the level of 1 m × 1 m or even when the power supply frequency is made to be higher. The plasma uniformity is important for etching, since the plasma uniformity affects the etching rate uniformity. Therefore, the plasma control method according to the invention is effective for plasma etching. In detail, an etching step may be provided to conduct etching on substrate 212 positioned on HF electrode 210 or on the earth electrode 211 using the plasma, whose distribution is controlled in the controlling step, and an etching gas made to flow from gas feeder line 202 into vacuum chamber 201.

The plasma control method is accomplished by making the voltage Vpp at the respective measuring points on HF electrode 210 nearly the same by controlling comprehensively one or more of the power of the electric power supply, the frequency of the electric power, the gas flow, the pressure in the vacuum chamber and a mixture ratio of the gases.

### Second embodiment

According to a second embodiment of the invention, a PCVD apparatus that enables depositing films by the stepping roll scheme in the same manner as according to the first embodiment is used. According to the second embodiment, the PCVD apparatus includes a control mechanism (automatic control means) that automatically controls, based on the values of the voltage Vpp measured at the respective measuring points, the film deposition pressure such that the differences between the absolute values of the measured voltage values are minimized (such that the voltage Vpp is nearly the same at all measuring points).

In detail, since the voltage Vpp measured at the lower measuring point is greatly different from the voltages Vpp measured at the other measuring points as described in connection with the first embodiment, the film deposition pressure is controlled so that the difference between the voltage Vpp at the upper measuring point and the voltage Vpp at the lower measuring point is minimum.

According to the second embodiment, the frequency of the HF power is set at 27 MHz. The other conditions are set to be the same as those according to the first embodiment. In the early stage of film deposition, the film deposition pressure is automatically controlled to be around 120 Pa. As FIG. 6 that describes the pressure dependence of the voltage Vpp indicates, the film deposition pressure of 120 Pa is in the vicinity of the pressure, at which the differences between the voltage values are minimum. Film deposition is conducted for 300 cells by the stepping role scheme.

FIG. 10 relates the automatically controlled pressure values with the number of the films deposited. In FIG. 10, the horizontal axis represents the number of the films deposited (sheets) and the vertical axis the automatically controlled pressure values (Pa). As FIG. 10 indicates, the pressure values lower with increasing number of sheets of deposited films.

FIG. 11 shows a couple of plots relating the relative stabilizing efficiencies of the solar cells with the number of the films deposited. In FIG. 11, the horizontal axis represents the number of the films deposited (sheets) and the vertical axis the stabilizing efficiencies (relative values). In FIG. 11, the black circles represent the results obtained under the uncontrolled film deposition pressures and the hatched triangles the results obtained under the automatically controlled film deposition pressures. As FIG. 11 indicates, the variations caused between the early stage of a lot manufacture and the late stage of the lot manufacture are reduced more effectively by the automatic pressure control as compared with the lot manufacture under the uncontrolled pressure. This is probably because the film thickness uniformity is improved by optimizing the film deposition pressure as compared with the film thickness uniformity obtained under the uncontrolled film deposition pressures and because the solar cell characteristics are improved somewhat due to the absolute values of the voltage Vpp lowered by from 10 V to 30 V.

As described above, a PCVD apparatus that facilitates depositing films by the stepping role scheme in the same manner as according to the first embodiment is used according to the second embodiment of the invention. According to the second embodiment, the PCVD apparatus is provided with a control mechanism that automatically controls the film deposition pressure based on the values of the voltage Vpp measured at the respective measuring points such that the differences between the absolute values of the voltage Vpp are minimized. In detail, the film deposition pressure is controlled based on the results of the plasma control according to the first embodiment so that the differences between the voltage Vpp at the upper measuring point and the voltage Vpp at the lower measuring point may be minimized.

According to the second embodiment, the HF power supply 205 is set to a frequency of 27 MHz and the other conditions are set to be the same as those according to the first embodiment. It has been made clear that the film deposition pressure is controlled automatically in the early stage of the film deposition to be around 120 Pa, at which the differences between the values of the voltage Vpp are minimum. It has been also made clear that the variations caused between the early stage of lot manufacture and the late stage of lot manufacture are reduced more by the automatic pressure control as compared with the lot manufacture under the uncontrolled pressure. Thus, by providing the plasma control apparatus according to the first embodiment with an automatic control mechanism that controls the film deposition pressure so that the differences between the absolute values of the voltage Vpp are minimized, the plasma control according to the second embodiment facilitates reducing the variations caused depending on the time of lot manufacture such as the early stage of lot manufacture and the late stage of lot manufacture in addition to exhibiting the effects which the plasma control according to the first embodiment exhibits. In other words, an automatic control mechanism, which relates the monitored peak-to-peak voltage values with the other film deposition conditions and controls the other film deposition conditions based on the monitored peak-to-peak voltage values, is disposed. The automatic control mechanism facilitates controlling the film deposition conditions in response to the variations caused in the absolute values and the distributions of the voltages Vpp on the HF electrode. Since the automatic control mechanism facilitates controlling the film deposition conditions in response to the variations caused not only from lot to lot but also in the process of lot manufacture such as the early stage of lot manufacture and the late stage of lot manufacture, the solar cells which exhibit excellent characteristics uniformity are manufactured and the throughput of the solar cell manufacture is improved.

The invention is applicable to manufacturing thin film solar cells using a PCVD apparatus and to etching using the plasma- CVD apparatus.

## Claims

1. A method of controlling the distribution of a plasma generated in a vacuum chamber including a first electrode (210) connected to a high-frequency electric power supply (205) and a second electrode (211) facing the first electrode (210), the second electrode (211) having the ground potential or another reference potential applied thereto, the plasma being generated by high-frequency electric power fed to the first electrode (210), the method comprising the step of:
a) measuring the peak-to-peak voltage of said high-frequency electric power at multiple points on the first electrode (210) and/or on the second electrode (211); and
b) controlling the distribution of the plasma based on the values of the peak-to-peak voltage measured at said multiple points.

2. The method according to Claim 1, wherein step b) comprises controlling the distribution of the plasma generated, whereby to set values of the peak-to-peak voltages measured at the multiple points to be nearly the same.

3. The method according to Claim 1, wherein step b) comprises controlling the pressure in the vacuum chamber so as to set the values of the peak-to-peak voltage measured at the multiple points to be nearly the same.

4. The method according to any of Claims 1 through 3, wherein step b) comprises using automatic control means to control the distribution of the plasma generated, whereby to set the values of the peak-to-peak voltage measured at the multiple points to be nearly the same.

5. The method according to Claim 4, wherein step b) comprises automatically controlling by the automatic control means the pressure in the vacuum chamber so as to set the values of the peak-to-peak voltage measured at the multiple points to be nearly the same.

6. The method according to any one of Claims 1 through 5, further comprising the step of:
c) depositing a thin film on a substrate positioned on the first electrode (210) or on the second electrode (211) under predetermined film deposition conditions using the plasma whose distribution is controlled in accordance with step b), and a film deposition gas made to flow onto the substrate in the vacuum chamber.

7. The method according to Claim 6, wherein step c) is performed with the ratio of the hydrogen amount in SiH₂ bondings to the hydrogen amount in SiH bondings (SiH₂/ SiH) in a non-crystalline photoelectric conversion layer selected to be 0.3 or smaller and the said values of the peak-to-peak voltage measured at the multiple points selected to be 300 V or lower, whereby to manufacture a solar cell comprising the non-crystalline photoelectric conversion layer.

8. The method according to any of Claims 1 through 5, further comprising the step of:
d) conducting etching on a substrate positioned on the first electrode (210) or on the second electrode (211), using the plasma controlled in accordance with step b), and an etching gas made to flow onto the substrate in the vacuum chamber.

9. A plasma control apparatus adapted to perform the method described in any one of Claims 1 through 8.
